# EUROPÄISCHE PATENTSCHRIFT

(11) **EP 0 943 965 B1**
(45) Veröffentlichungstag und Bekanntmachung des Hinweises auf die Patenterteilung: **24.09.2003**
(21) Anmeldenummer: 99105313.3
(22) Anmeldetag: 16.03.1999
(51) Int. Cl.: G03F 7/32

(54) **Entwickler und Verfahren zur Herstellung von flexographischen Druckformen**
Developer and method of producing flexographic printing forms
Développateur et méthode de préparation de clichés flexographiques

(30) Priorität: 16.03.1998 DE 19811330
(43) Veröffentlichungstag der Anmeldung: 22.09.1999
(73) Patentinhaber: DU PONT DE NEMOURS (DEUTSCHLAND) GMBH, 61352 Bad Homburg (DE); E.I. DU PONT DE NEMOURS AND COMPANY, Wilmington Delaware 19898 (US)
(72) Erfinder: Kraska, Ursula Dr., 64331 Weiterstadt (DE); Hirse, Ute, 64287 Darmstadt (DE)
(74) Vertreter: Dettmer, Heike, Dr.

(56) Entgegenhaltungen:
- EP-A- 0 180 122
- US-A- 3 989 634

## Beschreibung

Die Erfindung betrifft einen wäßrigen Entwickler und ein Verfahren zur Herstellung von flexographischen Druckformen durch bildmäßiges Belichten eines Aufzeichnungsmaterials, Auswaschen der unvernetzten Schichtanteile mit dem speziellen wäßrigen Entwickler und Trocknen des so behandelten Aufzeichnungsmaterials.

Es ist bekannt, für die Herstellung von flexographischen Druckformen photopolymerisierbare Druckplatten zu verwenden, bei denen die Druckoberfläche durch bildmäßiges Belichten einer durch aktinische Strahlung photopolymerisierbaren Schicht und anschließendes Entfernen der unbelichteten, nicht photopolymerisierten Druckplattenbereiche erzeugt wird. Als Entwicklerlösemittel werden hierbei üblicherweise je nach Bindemittel wäßrige Lösungen oder organische Lösemittel verwendet.

Wegen der geringeren Umweltbelastung und verminderten Gesundheitsgefährdung werden in den letzten Jahren mehr und mehr wäßrige Entwickler eingesetzt. Als wäßrige Entwickler werden z. B. wäßrige Lösungen von Alkalimetallhydroxiden oder -carbonaten und auch wäßrige Lösungen von ionischen oder nicht ionischen Netzmitteln verwendet. Netzmittel enthaltende Entwickler sind in der JP 6-297829 beschrieben. In der US 3,989,634 werden Waschmittel beschrieben, die neben den üblichen Komponenten ein flüssiges Tensid enthalten, das neben vielen anderen das Trinatriumsalz des Octadecylamids von Ethylendiamintetraacetat ein kann.

Der Auswaschprozess wird meist in Auswaschgeräten mit rotierenden Bürsten aus unterschiedlichen Materialien durchgeführt. Sowohl anorganische wie auch netzmittelhaltige Entwickler führen hierbei oft zu Ablagerungen des ausgewaschenen Materials sowohl auf den Bürsten und der Bürstenplatte als auch auf den Gerätewänden. Solche Ablagerungen, oft klebrige Polymerfilamente finden sich insbesondere an den Bürstenansätzen. Durch diese Ablagerungen wird die Qualität des Auswaschprozesses beeinträchtigt. Da dies nicht hinnehmbar ist, muss frühzeitig der Entwickler gewechselt werden und das Auswaschgerät, oft sehr zeit- und arbeitsaufwendig, gereinigt werden. Zudem führt die Ablagerung von Photopolymerresten auf der Druckform, insbesondere in den Negativlinien und zwischen den Rasterelementen, zu schlechten, unsauberen Druckbildern.

Aufgabe der vorliegenden Erfindung war es daher, den Auswaschprozess wäßrig entwicklerbarer Flexodruckplatten zu verbessern, wobei insbesondere die Ablagerung von Photopolymermaterial im Prozessor, in den Bürsten und auf der Druckplattenoberfläche vermieden werden soll.

Diese Aufgabe wird gelöst durch ein Verfahren zur Herstellung von flexographischen Druckformen durch bildmäßiges Belichten eines Aufzeichnungsmaterials umfassend ein Trägermaterial und mindestens eine mit aktinischer Strahlung vernetzbare Schicht, mit aktinischer Strahlung unter Vernetzung der belichteten Schichtanteile, b) Auswaschen der unvernetzten Schichtanteile mit einem wäßrigen Entwickler und c) Trocknen des so behandelten Aufzeichnungsmaterials, dadurch gekennzeichnet, dass ein wäßriger Entwickler enthaltend mindestens ein Trialkalisalz eines N-Alkylamidocarboxymethylen-N',N'',N"-tris-(carboxymethylen)ethylendiamins mit einem langkettigen, aliphatischen Kohlenwasserstoffrest in der N-Alkylamidogruppe verwendet wird, durch einen wäßriger Entwickler enthaltend mindestens ein solches Ethylendiaminderivates und mindestens eine Aminocarbonsäure oder mindestens eine Fettsäure und durch ein Entwicklerkonzentrat enthaltend Wasser, 10 bis 90 Gew.-% mindestens eines solchen Ethylendiaminderivates, 5 bis 50 Gew.- % mindestens eines Aminoalkohols und 5 bis 50 Gew.-% mindestens einer Fettsäure.

Überraschenderweise bildet der erfindungsgemäße Entwickler homogene Dispersionen des ausgewaschenen Photopolymermaterials und führt nur zu geringen Ablagerungen im Prozessor, sowohl an den Prozessorbürsten als auch an den Prozessorwänden, bei gleichzeitig hoher Auswaschgeschwindigkeit. Auch bei höherer Beladung des Entwicklers mit ausgewaschenem Photopolymermaterial treten keine klebrigen, schwer zu entfernenden Ablagerungen auf, sondern es bilden sich feine, meist brüchige Filamente, die leicht zu entfernen sind. Die Oberflächen der mit dem erfindungsgemäßen Entwickler hergestellten Druckformen sind frei von Ablagerungen und führen somit zu einwandfreien Druckergebissen.

Diese Vorteile des erfindungswesentlichen Entwicklers waren umso überraschender als ähnliche Netzmittel, wie z. B. das aus der JP6-297829 bekannte Kokossäurediethanolamid und Lauroylethylendiamintriacetat, beschrieben in Inform,Vol. 6, Nr. 10 (Oktober 1995), eine sehr starke Verschmutzung der Bürsten und Auswaschgeräte bewirken.

Als erfindungswesentliche Komponente enthält der vorliegende wäßrige Entwickler mindestens ein Trialkalisalz eines N-Alkylamidocarboximethylen-N',N'',N''-tris-(carboximethylen)ethylendiamins mit einem langkettigen, aliphatischen Kohlenwasserstoffrest in der N-Alkylamidogruppe. Diese Ethylendiamintriacetat-alkylacetamide werden bevorzugt in Mengen von 0,1 Gew.-% oder mehr verwendet, besonders bevorzugt 0,2 bis 5 Gew.-%. Insbesondere 0,2 bis 3 Gew.-% sind vorteilhaft. Als Alkalisalze werden bevorzugt die Natriumsalze verwendet. Langkettige, aliphatische Kohlenwasserstoffreste in der N-Alkylamidogruppe sind bevorzugt solche mit 6 bis 22 Kohlenstoffatomen in der Kette wie sie z. B. in den Kohlenwasserstoffketten (einschließlich der Carboxylgruppe) der Capryl-, Caprin-, Laurin-, Myristin-, Palmitin- und Ölsäure vorliegen. Auch Gemische hiervon sind geeignet. Besonders bevorzugt werden Gemische verwendet, die auf Kokosfettsäuren beruhen. Besonders geeignet ist Ethylendiamintriacetat-kokosalkylacetamid Trinatriumsalz.

Als Zusatz kann der erfindungsgemäße Entwickler einen Aminoalkohol und/oder eine Aminocarbonsäure enthalten, da hierdurch die Auswaschgeschwindigkeit erhöht wird. Bevorzugt werden Triethanolamin, Tris(hydroxymethyl)aminomethan und Nitrilotriessigsäure verwendet. Die Menge dieser Zusätze beträgt bevorzugt 0,05 bis 1,0 Gew.-%, insbesondere 0,1 bis 0,6 Gew.-%.

Desweiteren können dem Entwickler Fettsäuren zugesetzt werden, bevorzugt 0,05 bis 1,0 Gew.-%, insbesondere 0,1 bis 0,5 Gew.-%. Insbesondere Ölsäure wird bevorzugt verwendet. Der Zusatz von Fettsäuren ist besonders vorteilhaft, da hierdurch die Polymerpartikel noch leichter zu entfernen sind.

Als weiteren Zusatz kann der erfindungsgemäße Entwickler eine Polyaminosäure enthalten. Bevorzugt wird Polyasparaginsäure verwendet. Die zugesetzte Menge beträgt bevorzugt 0,05 bis 2,0 Gew.-%, insbesondere 0,1 bis 1,0 Gew.-%.

Der vorliegende Entwickler wird durch Auflösen der entsprechenden Mengen der zu verwendenden Komponenten in Wasser vor dem Entwicklungsprozess hergestellt. Es ist aber auch möglich, ein Konzentrat der Komponenten herzustellen, und dieses erst kurz vor Beginn des Auswaschprozess mit Wasser auf die erforderliche Konzentration zu verdünnen. Solche Konzentrate enthalten üblicherweise Wasser, 10 bis 90 Gew.-%, bevorzugt 30 bis 60 Gew.-%, mindestens eines erfindungswesentlichen Ethylendiaminderivates, 5 bis 50 Gew.-%, bevorzugt 15 bis 35 Gew.-%, mindestens eines Aminoalkohols und 5 bis 50 Gew.-%, bevorzugt 15 bis 35 Gew.-%, mindestens einer Fettsäure. Zur Herstellung einer gebrauchsfähigen Entwicklerlösung wird das Konzentrat mit Wasser vedünnt. Diese Lösung enthält bevorzugt 0,1 bis 10 Gew.-%, insbesondere 0,5 bis 5 Gew.-% des Konzentrats. Besonders bevorzugt werden 0,5 bis 3 Gew.-% des Konzentrats eingesetzt.

Der Entwickler der vorliegenden Erfindung kann in allen herkömmlichen Auswaschgeräten, bevorzugt in Edelstahlgeräten,verwendet werden. Alle gängigen Bürstenmaterialien, wie z.B. Nylon, Polyester oder Polypropylen, können eingesetzt werden. Der Auswaschprozess wird bevorzugt bei erhöhter Temperatur durchgeführt, üblicherweise bei ≥ 30 °C, insbesondere bei 50 °C.

Der pH-Wert des erfindungsgemäßen Entwicklers beträgt üblicherweise 8-11, bevorzugt 8-10.

Der vorliegende Entwickler eignet sich für die Entwicklung von wäßrig entwickelbaren Aufzeichnungsmaterialien mit photopolymerisierbaren Schichten. Bevorzugt enthalten diese Schichten hydrophile Polymere, ggf. hydrophobe Polymere, photopolymerisierbare Monomere, Photoinitiatoren und weitere Hilfsstoffe wie Weichmacher, Füllstoffe, Stabilisatoren, Farbstoffe, Inhibitoren, etc.

Als wesentliche Bindemittel enthalten wäßrig entwickelbare Druckplatten Polymere mit hydrophilen Gruppen wie z. B. Hydroxyl-, Carboxyl-, Amino-, Nitril-, Schwefelsäureester- und Phosphorsäureestergruppen oder auch Kombinationen dieser Gruppen, genannt seien z. B. Polyvinylalkohole, Polyvinylacetate, Copolymere aus (Meth)acrylsäure und (Meth)acrylaten, Cellulosederivate, Polyester, Polyamide, carboxylierte Butadien-Acrylnitrilpolymere, Core-Shell-Polymere mit hydrophilen Gruppen in den Shell-Polymeren oder Blockcopolymere mit hydrophoben und hydrophilen Blöcken. Auch Gemische verschiedener dieser Polymere werden verwendet oder Gemische mit hydrophoben Bindemitteln wie thermoplastisch elastomeren Copolymeren, insbesondere mit thermoplastisch elastomeren Blockcopolymeren. Bevorzugt werden lineare und radiale Polystyrol-Polybutadien-Polystyrol- bzw. Polystyrol-Polyisopren-Polystyrol-Blockcopolymere verwendet. Wäßrig entwickelbare Flexodruckplatten sind z. B. in US 5,175,076; EP-A 0 784 232; US 4,621,044; US 4,177,074; und US 5,075,192 beschrieben.

Die photopolymerisierbaren Materialien können nach gängigen Methoden auf handelsübliche Trägermaterialien aufgebracht und bildmäßig belichtet werden. Nach der Entwicklung mit dem erfindungsgemäßen Entwickler erfolgt die Trocknung der Druckformen, woran ggf. eine chemische Nachbehandlung und/oder eine Nachbelichtung angeschlossen werden kann.

Die folgenden Beispiele sollen die vorliegende Erfindung verdeutlichen. Die angegebenen Teile und Prozente beziehen sich, falls nichts anderes angegeben ist, auf das Gewicht.

### Beispiele und Vergleichsversuche

In den folgenden Beispielen und Vergleichsbeispielen wurde die Auswaschzeit durch Bestimmung der Relieftiefen nach 8/10/12/14/16 min und anschließender Regressionsanalyse ermittelt und auf 1 mm Relieftiefe normiert. Die Auswaschzeiten wurden von frischem sowie von mit 3 bzw. 6 Gew.-% Photopolymer beladenem wäßrigen Entwickler bestimmt. Die Bürsten- und Prozessor-Verschmutzung wurden visuell beurteilt.

Es wurden handelsübliche wäßrig auswaschbare Cyrel® AQS Flexodruckplatten (1,70 mm Dicke) verwendet. Eine solche Flexodruckplatte wurde zunächst 8 sec von ihrer Rückseite her in einem Röhrenbelichter ( DuPont Cyrel® 1001 Belichter; 60 sec = 700 mJ/cm²) vollflächig vorbelichtet, anschließend 8 min durch eine Negativvorlage bildmäßig belichtet und bei 50° C in einem handelsüblichen Bürstenprozessor DuPont Cyrel®AQS 24x30 (Nylonbürsten, Bürstenfläche 72 x 87 cm²) mit den zu untersuchenden wäßrigen Entwicklern behandelt. Dabei entspricht der Gewichtsprozentgehalt x an in wäßriger Lösung dispergiertem, unbelichtetem Photopolymermaterial einer x%igen Beladung (z. B. sind bei 3%iger Beladung 3 kg unbelichtetes Photopolymermaterial in 100 kg Lösung enthalten). Der pH-Wert wurde jeweils bei frisch angesetzter Lösung und nach 6%iger Beladung bestimmt.

### Beispiel 1

Als Entwickler wurde eine 0,6 %ige wäßrige Lösung (voll entsalztes Wasser) von Ethylendiamintriacetat-kokosalkylacetamid Trinatriumsalz (CAS-Nr. 93 165-97-0) eingesetzt. Die Auswaschzeiten betrugen: 22, 27 und 36 min. Der pH-Wert änderte sich von 10,5 auf 8,9. Bis zu einer Beladung von 3% waren nur Spuren feiner Polymerfilamente zu erkennen, die bis 6% Beladung leicht zunahmen.

### Beispiel 2

Als Entwickler wurde eine 2 %ige wäßrige Lösung (voll entsalztes Wasser) von Ethylendiamintriacetat-kokosalkylacetamid Trinatriumsalz (CAS-Nr. 93 165-97-0) eingesetzt. Die Auswaschzeiten betrugen: 21, 27 und 28 min. Der pH-Wert änderte sich von 10,9 auf 9,9. Bis zu einer Beladung von 3% waren die Bürsten vollkommen sauber. Ab 4%iger Beladung setzten sich feine, leicht entfernbare Filamente in der Tiefe der Bürstenbüschel ab.

### Beispiel 3

Dem Entwickler aus Beispiel 1 wurden 0,3 % Tris(hydroxymethyl)aminomethan zugesetzt. Die Auswaschzeiten betrugen: 12, 13 und 13 min. Der pH-Wert änderte sich von 10,6 auf 9,2. Der Grad an Verschmutzung entsprach dem von Beispiel 1.

### Beispiel 4

Dem Entwickler aus Beispiel 1 wurden 0,3 % Triethanolamin zugesetzt. Die Auswaschzeiten betrugen: 12, 13 und 13 min. Der pH-Wert änderte sich von 10,8 auf 9,4. Der Grad an Verschmutzung entsprach dem von Beispiel 1.

### Beispiel 5

Es wurden wäßrige Lösungen, a) voll entsalztes Wasser und b) Leitungswasser mit einer Härte von 8° dH (deutsche Härte), von 0,5 % Ethylendiamintriacetat-kokosalkylacetamid trinatriumsalz, 0,3 % Triethanolamin und 0,2 % Ölsäure als Entwickler eingesetzt. Die Auswaschzeiten betrugen für die Variante a) 15, 18 und 18 min und für b) 19, 20 und 22 min. Der pH-Wert änderte sich für a) von 9,1 auf 8,7 und für b) von 9,2 auf 8,8. Bis 3% Beladung war keine Verschmutzung zu erkennen und auch bei stärkerer Beladung (bis 6%) nahm die Verschmutzung nur wenig zu. Die wenigen Polymerfilamente und die geringfügige Prozessor-Verschmutzung waren wegen der geringen Klebrigkeit der Polymerpartikel leicht zu entfernen.

### Beispiel 6

Es wurde eine wäßrige Lösung (voll entsalztes Wasser) von 0,3 % Ethylendiamintriacetat-kokosalkylacetamid Trinatriumsalz, 0,3 % Triethanolamin und 0,2 % Ölsäure als Entwickler eingesetzt. Die Auswaschzeiten betrugen: 18, 19 und 19 min. Der pH-Wert änderte sich von 8,8 auf 8,6. Bis 3% Beladung waren nur Spuren von Filamenten zu erkennen, und die Verschmutzung nahm auch bei stärkerer Beladung (bis 6%) nicht wesentlich zu. Die wenigen Polymerfilamente und die geringfügige Prozessor-Verschmutzung waren wegen der geringen Klebrigkeit der Polymerpartikel leicht zu entfernen.

### Beispiel 7

Es wurde eine wäßrige Lösung (voll entsalztes Wasser) von 0,8 % Ethylendiamintriacetat-kokosalkylacetamid Trinatriumsalz, 0,2 % Triethanolamin und 0,2 % Ölsäure als Entwickler eingesetzt. Die Auswaschzeiten betrugen: 17, 18 und 20 min. Der pH-Wert änderte sich von 9,6 auf 8,8. Bis 4 % war keine Verschmutzung zu erkennen und nahm auch bei stärkerer Beladung (bis 6%) kaum zu. Die wenigen Polymerfilamente und die geringfügige Prozessor-Verschmutzung waren wegen der geringen Klebrigkeit der Polymerpartikel leicht zu entfernen.

### Beispiel 8

Es wurde eine wäßrige Lösung (voll entsalztes Wasser) von 0,6 % Ethylendiamintriacetat-kokosalkylacetamid trinatriumsalz, 0,3 % Tris(hydroxymethyl)aminomethan, 0,2 % Ölsäure und 0,5 % Polyasparaginsäure als Entwickler eingesetzt. Die Auswaschzeiten betrugen: 12, 14 und 14 min. Der pH-Wert änderte sich von 9,3 auf 8,9. Bis 4 % war keine Verschmutzung zu erkennen und nahm auch bei stärkerer Beladung (bis 6%) nur wenig zu. Die wenigen Polymerfilamente waren sehr klein und die Prozessor-Verschmutzung war sehr gering.

### Beispiel 9

Es wurde der Entwickler des Beispiels 8 eingesetzt, jedoch mit Leitungswasser mit einer Härte von 17-18°dH (deutsche Härte) anstatt voll entsalztem Wasser. Die Auswaschzeiten betrugen: 14, 15 und 15 min. Der pH-Wert änderte sich von 9,1 auf 8,9. Bis 3 % war keine Verschmutzung zu erkennen und nahm auch bei stärkerer Beladung (bis 6%) nur wenig zu. Die wenigen Polymerfilamente und die geringfügige Prozessor-Verschmutzung waren wegen der geringen Klebrigkeit der Polymerpartikel leicht zu entfernen.

### Vergleichsversuch 1

Als Entwickler wurde eine 1 %ige wäßrige Lösung von Kokossäurediethanolamid (Reaktionsprodukt von 1 mol Kokossäure und 2 mol Diethanolamin) eingesetzt. Die Auswaschzeiten betrugen: 16, 16 und 26 min. Der pH-Wert änderte sich von 9,4 auf 8,9. Bereits bei 1%iger Beladung waren deutlich Polymerfilamente in den Bürsten sichtbar, die mit zunehmender Beladung mit Photopolymer sehr schnell stärker wurden. Bei 6%iger Beladung waren Bürsten und Prozesssor total verschmutzt und erforderten eine sehr aufwendige Reinigung.

### Vergleichsversuch 2

Als Entwickler wurden 0,3; 0,5; 0,7 und 1%ige wäßrige Lösungen von Lauroylethylendiamintriacetat eingesetzt. Die Auswaschzeiten der frischen Lösungen ergaben bei 0,3% - 67 min; bei 0,5% - 48 min; bei 0,7% - 37 min und bei 1% - 28 min. Der pH-Wert lag jeweils bei 4,8. Bürsten und Prozessor waren bei allen Lösungen bereits bei geringen Konzentrationen stark verschmutzt und konnten nur unter großem zeitlichen und manuellen Aufwand gereinigt werden, da die Ablagerungen sehr klebrig waren.

### Vergleichsversuch 3

Als Entwickler wurde eine 0,5%ige wäßrige Lösung eines weit verbreiteten Tensids, Natriumlaurylsulfat eingesetzt. Die Auswaschzeiten der frischen Lösung betrugen 27, 29 und 32 min. Zwischen 2 und 6%iger Beladung nahm die Verschmutzung kontinuierlich zu. Ab 4%iger Beladung setzten sich bereits ausgewaschene Filamente, die aufgrund ihrer Klebrigkeit kaum zu entfernen waren, auf der Plattenoberfläche ab.

## Patentansprüche

1. Verfahren zur Herstellung von flexographischen Druckformen durch
a) bildmäßiges Belichten eines Aufzeichnungsmaterials umfassend ein Trägermaterial und mindestens eine mit aktinischer Strahlung vernetzbare Schicht, mit aktinischer Strahlung unter Vernetzung der belichteten Schichtanteile,
b) Auswaschen der unvernetzten Schichtanteile mit einem wäßrigen Entwickler und
c) Trocknen des so behandelten Aufzeichnungsmaterials,
**dadurch gekennzeichnet, dass**
ein wäßriger Entwickler enthaltend mindestens ein Trialkalisalz eines N-Alkylamidocarboxymethylen-N',N",N"-tris-(carboxymethylen)ethylendiamins mit einem langkettigen, aliphatischen Kohlenwasserstoffrest in der N-Alkylamidogruppe verwendet wird.

2. Verfahren nach Anspruch 1,
**dadurch gekennzeichnet, dass**
0,2 bis 5 Gew.-% des oder der Ethylendiaminderivate enthalten sind.

3. Verfahren nach einem der Ansprüche 1 oder 2,
**dadurch gekennzeichnet, dass**
Alkylreste mit 6-22 Kohlenstoffatomen verwendet werden.

4. Verfahren nach einem der Ansprüche 1 bis 3,
**dadurch gekennzeichnet, dass**
Alkylreste entsprechend der Kohlenwasserstoffkette der Capryl-, Caprin-, Laurin-, Myristin-, Palmitin- und/oder Ölsäure verwendet werden.

5. Verfahren nach einem der Ansprüche 1 bis 4,
**dadurch gekennzeichnet, dass**
Alkylreste entsprechend den Kohlenwasserstoffketten der Kokosfettsäuren verwendet werden.

6. Verfahren nach einem der Ansprüche 1 bis 5,
**dadurch gekennzeichnet, dass**
als Zusatz mindestens ein Aminoalkohol und/oder mindestens eine Aminocarbonsäure enthalten ist.

7. Verfahren nach einem der Ansprüche 1 bis 6,
**dadurch gekennzeichnet, dass**
als Zusatz mindestens eine Fettsäure enthalten ist.

8. Verfahren nach einem der Ansprüche 1 bis 7,
**dadurch gekennzeichnet, dass**
als Zusatz mindestens eine Polyaminosäure, bevorzugt Polyasparaginsäure, enthalten ist.

9. Wäßriger Entwickler für photopolymerisierbare flexographische Druckplatten, enthaltend mindestens ein Trialkalisalz eines N-Alkylamidocarboxymethylen-N',N",N"-tris-(carboxymethylen)ethylendiamins mit einem langkettigen, aliphatischen Kohlenwasserstoffrest in der N-Alkylamidogruppe und mindestens eine Aminocarbonsäure.

10. Wäßriger Entwickler für photopolymerisierbare flexographische Druckplatten, enthaltend mindestens ein Trialkalisalz eines N-Alkylamidocarboxymethylen-N',N",N"-tris-(carboxymethylen)ethylendiamins mit einem langkettigen, aliphatischen Kohlenwasserstoffrest in der N-Alkylamidogruppe und mindestens eine Fettsäure.

11. Entwicklerkonzentrat zur Herstellung eines wäßrigen Entwicklers für photopolymerisierbare flexographische Druckplatten, enthaltend Wasser, 10 bis 90 Gew.-% mindestens eines Ethylendiaminderivates gemäß Anspruch 1, 5 bis 50 Gew.- % mindestens eines Aminoalkohols und 5 bis 50 Gew.- % mindestens einer Fettsäure.

## Claims

1. A process for preparing flexographic printing forms by
a) imagewise exposing of a recording material comprising a support and at least one layer crosslinkable by actinic radiation, with actinic radiation crosslinking the exposed areas of the layer,
b) washing off the uncrosslinked areas of the layer with an aqueous developer, and
c) drying the treated recording material,
**characterized in that**,
an aqueous developer compring at least one trialkali salt of an N-alkylamidocarboxymethylene-N',N",N"-tris(carboxymethylene)-ethylenediamine having a long-chain, aliphatic hydrocarbon radical in the N-alkylamido group is used.

2. The process according to Claim 1,
**characterized in that**,
0.2 to 5 percent by weight of the ethylenediamine derivatives are included.

3. The process according to one of the claims 1 or 2,
**characterized in that**,
hydrocarbon radicals comprising 6-22 carbon atoms are used.

4. The process according to one of claims 1 to 3,
**characterized in that**,
hydrocarbon radicals according to the hydrocarbon chain of caprilic, capric, lauric, myristic, palmitic, and/or oleic acid are used.

5. The process according to one of claims 1 to 4,
**characterized in that**,
hydrocarbon radicals according to the hydrocarbon chain of coconut oil acids are used

6. The process according to one of claims 1 to 5,
**characterized in that**,
at least one amino alcohol and/or at least one amino carboxylic acid is included as an additive.

7. The process according to one of claims 1 to 6,
**characterized in that**,
at least one fatty acid is included as an additive.

8. The process according to one of claims 1 to 7,
**characterized in that**,
at least one polyamino acid, preferably polyaspartic acid, is included as an additive.

9. An aqueous developer for photopolymerizable flexographic printing plates containing at least one trialkali salt of an N-alkylamidocarboxymethylene-N',N",N"-tris-(carboxymethylene)-ethylenediamine having a long-chain, aliphatic hydrocarbon radical in the N-alkylamido group and at least one amino carboxylic acid.

10. An aqueous developer for photopolymerizable flexographic printing plates containing at least one trialkali salt of an N-alkylamidocarboxymethylene-N',N",N"-tris-(carboxymethylene)-ethylenediamine having a long-chain, aliphatic hydrocarbon radical in the N-alkylamido group and at least one fatty acid.

11. A developer concentrate for preparing an aqueous developer for photopolymerizable flexographic printing plates, containing water, 10 to 90 percent by weight of at least one trialkali salt of one ethylenediamine derivative according to claim 1, 5 to 50 percent by weight of at least one amino alcohol, and 5 to 50 percent by weight of at least one fatty acid.

## Revendications

1. Procédé de fabrication de clichés flexographiques par
a) exposition par image d'un matériau d'enregistrement se composant d'un matériau support et d'au moins une couche réticulable à l'aide d'un rayonnement actinique, avec rayonnement actinique sous réticulation des portions de couche illuminées,
b) élimination par lavage des portions de couche non réticulées à l'aide d'un agent de développement aqueux et
c) séchage du matériau d'enregistrement ainsi traité
**caractérisé en ce que** l'on utilise un agent de développement aqueux contenant au moins un sel tri alcalin d'une N-alkylamidocarboxyméthylène-N',N",N"-tris-(carboxyméthylène)éthylènediamine, avec un résidu d'hydrocarbure aliphatique à longue chaîne dans le groupement N-alkylamido.

2. Procédé selon la revendication 1, **caractérisé en ce que** de 0,2 à 5% en poids de la ou des dérivés de l'éthylènediamine sont contenus.

3. Procédé selon l'une quelconque des revendications 1 ou 2, **caractérisé en ce que** l'on utilise des résidus alkyles ayant 6-22 atomes de carbone.

4. Procédé selon l'une quelconque des revendications 1 à 3, **caractérisé en ce que** l'on utilise des résidus alkyles correspondant à la chaîne d'hydrocarbures des acides caprylique, caprique, laurique, myristique, palmitique et/ou oléique.

5. Procédé selon l'une quelconque des revendications 1 à 4, **caractérisé en ce que** l'on utilise des résidus alkyles correspondant aux chaînes d'hydrocarbures de l'acide de l'huile de coco.

6. Procédé selon l'une quelconque des revendications 1 à 5, **caractérisé en ce qu'**en addition est contenu au moins un aminoalcool et/ou au moins un aminoacide.

7. Procédé selon l'une quelconque des revendications 1 à 6, **caractérisé en ce qu'**en addition est contenu au moins un acide gras.

8. Procédé selon l'une quelconque des revendications 1 à 7, **caractérisé en ce qu'**en addition est contenu au moins un polyaminoacide, de préférence l'acide polyaspartique.

9. Agent de développement aqueux pour planches d'impression flexographiques photo polymérisables, contenant au moins un sel tri alcalin d'une N-alkylamidocarboxyméthylène-N',N",N"-tris-(carboxyméthylène)éthylènediamine, avec un résidu d'hydrocarbure aliphatique à longue chaîne dans le groupement N-alkylamido et au moins un aminoacide.

10. Agent de développement aqueux pour planches d'impression flexographiques photo polymérisables, contenant au moins un sel tri alcalin d'une N-alkylamidocarboxyméthylène-N',N",N'''-tris-(carboxyméthylène)éthylènediamine, avec un résidu d'hydrocarbure aliphatique à longue chaîne dans le groupement N-alkylamido et au moins un acide gras.

11. Concentré d'agent de développement en vue de la fabrication d'un agent de développement aqueux pour des planches d'impression flexographiques photopolymérisables, contenant de l'eau, de 10 à 90% en poids d'au moins un dérivé d'éthylènediamine selon la revendication 1, de 5 à 50% en poids d'au moins un aminoalcool et de 5 à 50% en poids d'au moins un acide gras.
